# EUROPÄISCHE PATENTANMELDUNG

(11) **EP 2 187 452 A2**
(43) Veröffentlichungstag der Anmeldung: **19.05.2010**
(21) Anmeldenummer: 09174084.5
(22) Anmeldetag: 26.10.2009
(51) Int. Cl.: H01L 31/18, H01L 31/02, H01L 31/0224

(54) **Verfahren zur Markierung/Kodierung einer Solarzelle und Solarzelle**

(30) Priorität: 14.11.2008 DE 102008043750
(71) Anmelder: Q-Cells SE, OT Thalheim 06766 Bitterfeld-Wolfen (DE)
(72) Erfinder: Falkner, Sebastian, 04158, Leipzig (DE); Weiß, Christian, 06766, Bobbau (DE)
(74) Vertreter: Reininger, Jan Christian

(57) **Zusammenfassung**

Verfahren zur Markierung einer Solarzelle (1) sowie Solarzelle (1), wobei eine Solarzelle (1) bereitgestellt wird, ein Kennzeichens ausgewählt wird, in einem Stellenwertsystem eine kodierten Zahl mittels Kodieren des Kennzeichens in das Stellenwertsystem ermittelt wird, wobei die Zahl in dem Stellenwertsystem das Kennzeichen repräsentiert, und ein Elektrodenfingermuster mit einer Mehrzahl von elektrisch leitenden Elektrodenfingern (3, 33, 35) auf einer Oberfläche der Solarzelle derart aufgebracht wird, dass die kodierte Zahl mittels einer geometrischen und / oder optischen Eigenschaft zumindest eines kodierenden Elektrodenfingers (35) aus der Mehrzahl von Elektrodenfingern (3, 33, 35) repräsentiert wird.

## Beschreibung

Die Erfindung betrifft ein Verfahren zur Markierung bzw. Codierung einer Solarzelle sowie eine Solarzelle.

Zur Unterscheidung von Solarzellen verschiedener Hersteller werden üblicherweise auf den sichtbaren Oberflächen der Solarzellen Markierungen angebracht, die den jeweiligen Hersteller kennzeichnen. Hierdurch besteht die Möglichkeit, bei Fehlfunktionen einer Solarzelle, den hierfür verantwortlichen Hersteller auf einen Blick festzustellen. Darüber hinaus kann es notwendig sein, unterschiedliche Solarzellentypen des gleichen Herstellers mit unterschiedlichen Markierungen zu kennzeichnen, beispielsweise um beim Zusammenbau von Modulen aus unterschiedlichen Solarzellenarten Verwechslungen vorzubeugen.

Auf den Solarzellenoberflächen kann eine Markierung (z.B. Hersteller-Logo) in der Regel in Form von Siebdruck-Markierungen angebracht werden. Diese bedeuten im Regelfall eine Abschattung, da sie meist alphanumerisch codiert werden. Um eine Abschattung der Solarzellenoberfläche zu minimieren, wird eine zusätzliche Codierung, z.B. des Solarzellentyps mittels alphanumerischen Markierungen, vermieden.

Derartige Markierungen haben ebenfalls den Nachteil, dass die von ihnen eingenommenen Solarzellenbereiche aufgrund von Abschattung oder anderer Beeinträchtigungen nicht für die Umwandlung von Licht in Solarstrom zur Verfügung stehen. Zudem werden für die Markierungen zusätzliche Materialien und möglicherweise weitere Arbeitsschritte benötigt.

Es ist daher Aufgabe der Erfindung, ein Verfahren sowie eine Solarzelle vorzuschlagen, bei denen eine Markierung/ Codierung einer Solarzelle effizient und kostengünstig sowie mit einer möglichst geringen Beeinflussung des Solarzellenwirkungsgrades erfolgt.

Diese Aufgabe wird durch ein Verfahren mit den Merkmalen des Anspruchs 1 sowie eine Solarzelle mit den Merkmalen des Anspruchs 15 gelöst. Vorteilhafte Weiterbildungen der Erfindung ergeben sich aus den Unteransprüchen.

Der Erfindung liegt die Überlegung zu Grunde, für die Markierung der Solarzelle die Elektrodenfinger oder Grid-Finger zu verwenden, welche - insbesondere bei frontseitenkontaktierten Solarzellen - ohnehin auf der Oberfläche der Solarzelle aufgetragen werden, um deren Funktion zu gewährleisten. Anstatt zusätzliches Material auf der Solarzellenoberfläche aufzutragen, um hierdurch eine Markierung zu bilden, werden die geometrischen und / oder optischen Eigenschaften der Elektrodenfinger derart gewählt, dass sie hierdurch eine kodierte Zahl darstellen können, und gleichzeitig ihre Funktionalität zur Stromentnahme aus der Solarzelle und / oder Stromweiterleitung beibehalten.

Um die Oberfläche der Solarzelle mit einem Kennzeichen zu markieren, wird das Kennzeichen zunächst in eine Zahl umgewandelt, welche in einem Stellenwertsystem kodiert ist. Bei dem Stellenwertsystem kann es sich beispielsweise um ein Binärsystem, ein Ternärsystem oder dergleichen handeln. Diese Zahl wird anschließend in der Weise in das Elektrodenfingermuster auf der Oberfläche der Solarzelle eingebracht, dass die Zahl aus den geometrischen und / oder optischen Eigenschaften der Elektrodenfinger abgelesen werden kann. Diese für die Kodierung der Zahl verwendeten Eigenschaften sind so zu wählen, dass sie keinen oder nur einen geringen, im Idealfall vernachlässigbaren, Einfluss auf die Funktionalität der Elektrodenfinger als Stromsammelelemente für die Solarzelle haben.

Die geometrischen und / oder optischen Eigenschaften können hierbei Eigenschaften umfassen, welche optisch auslesbar sind. Beispiele für geometrische Eigenschaften sind Dicke, Breite, Länge, Orientierung und Position eines Elektrodenfingers sowie der Abstand zwischen mehreren Elektrodenfingern. Kumulativ oder alternativ eignen sich hierfür ebenso optische Eigenschaften wie zum Beispiel die Reflexivität eines Elektrodenfingers und seine Durchlässigkeit oder sein Absorptionsvermögen für elektromagnetische Strahlung beispielsweise im sichtbaren, infraroten oder ultravioletten Bereich. Im Sinne der vorliegenden Erfindung werden als Elektrodenfinger Leiterabschnitte auf der Solarzellenoberfläche bezeichnet, die in ihrer Erstreckungsrichtung gestreckt sind und zum Entnehmen, Sammeln und / oder Weiterleiten der Solarzelle erzeugter Ströme vorgesehen sind, somit ebenfalls kürzere Verbindungsstücke, welche als Brückenelemente längere, üblicherweise über fast die gesamte Breite der Oberfläche verlaufende Leiterabschnitte miteinander verbinden.

Bevorzugt handelt es sich bei dieser, die Solarzelle kenntlich machende geometrische und / oder optische Eigenschaft um eine von den übrigen Elektrodenfingern des Elektrodenfingermusters abweichende Eigenschaft, beispielsweise um eine Versetzung gegenüber benachbarten Elektrodenfingern oder einer gegenüber den übrigen Elektrodenfingern erhöhte oder verminderte Elektrodenbreite.

Auch in diesem Fall ist es wichtig, dass der markierende Elektrodenfinger die gleichen elektrischen Funktionen erfüllt, wie die nichtmarkierenden Elektrodenfinger und nur zusätzlich durch seine Position auf der Substratoberfläche oder anderen geometrischen und / oder optischen Eigenschaften die Solarzelle beispielsweise als zu einem bestimmten Serientyp gehörend kennzeichnet.

Neben dem Verfahren wird eine Solarzelle mit folgenden Merkmalen offenbart. Die Solarzelle weist eine Oberfläche mit einem auf der Oberfläche aufgebrachten Elektrodenfingermuster mit einer Mehrzahl elektrisch leitender Elektrodenfinger auf, wobei mindestens ein elektrisch leitender Elektrodenfinger als kodierender Elektrodenfinger ausgebildet ist, dadurch dass der kodierende Elektrodenfinger geometrische und / oder optische Eigenschaften umfasst, die ein Kennzeichen der Solarzelle repräsentieren. Kennzeichen können alle erdenklichen Eigenschaften der Solarzelle sein. Beispiele für ein Kennzeichen sind der Serientyp der Zelle, definierte funktionale Eigenschaften für bestimmte Einsatzzwecke oder Betriebsszenarien. Eine bevorzugte Variante dieser Solarzelle stellt die vorangehend im Zusammenhang mit dem Verfahren erläuterte Definition des Kennzeichens dar. Insofern ist eine nach diesem Verfahren hergestellte Solarzelle ebenfalls offenbart. Zur Vermeidung von Wiederholungen sind die nachfolgend erläuterten bevorzugten Varianten des Herstellungsverfahrens nicht noch einmal für die aus diesen Verfahren resultierenden Vorrichtungen in Form von Solarzellen wiederholt worden. Es wird ausdrücklich betont, dass mit der nachfolgenden Erläuterung bevorzugter Herstellungs-Verfahrensschritte entsprechende hergestellte Solarzellen mit entsprechenden strukturellen und funktionalen Merkmalen für den Fachmann klar offenbart sind.

In einer bevorzugten Ausführungsform des Verfahrens ist vorgesehen, dass beim Aufbringen des Elektrodenfingermusters jede Ziffer der kodierten Zahl mittels einer geometrischen und / oder optischen Eigenschaft zumindest eines kodierenden Elektrodenfingers aus der Mehrzahl von Elektrodenfingern repräsentiert wird. Hierbei wird der Begriff "Ziffer" als Synonym für eine Stelle der Zahl in dem Stellenwertsystem verwendet.

Beim Aufbringen des Elektrodenfingermusters umfasst die geometrische und / oder optische Eigenschaft des zumindest einen kodierenden Elektrodenfingers, mittels der die Ziffer der Zahl repräsentiert wird, in einer zweckmäßigen Ausführungsform eine Abweichung in der Geometrie und / oder in den optischen Eigenschaften des zumindest einen kodierenden Elektrodenfingers gegenüber nichtkodierenden Elektrodenfingern aus der Mehrzahl von Elektrodenfingern. Mit anderen Worten, bei den geometrischen und / oder optischen Eigenschaften der kodierenden Elektrodenfinger, mittels der die kodierte Zahl umgesetzt wird, handelt es sich um relative Eigenschaften, die mittels eines Vergleichs mit den entsprechenden Eigenschaften der nichtkodierenden Elektrodenfinger auslesbar sind. Beispielsweise kann eine bestimmte Dicke des kodierenden Elektrodenfingers oder sein Abstand zu einem Solarzellenrand in einem Binärsystem eine logische 1 repräsentieren, wenn sie von der Dicke eines nichtkodierenden Elektrodenfingers oder seinem Abstand vom Solarzellenrand abweicht. Andernfalls repräsentiert sie im Binärsystem eine logische 0.

Bei einer vorteilhaften Ausgestaltung umfasst die geometrische Eigenschaft eine Versetzung des kodierenden Elektrodenfingers gegenüber den nichtkodierenden Elektrodenfingern. Handelt es sich bei dem Stellenwertsystem um ein Binärsystem, so kann bereits das Vorhandensein einer Versetzung eine logische 1 darstellen. Bei einem Ternärsystem, oder allgemein bei Stellenwertsystemen mit der Basis n, weist die besagte Versetzung des kodierenden Elektrodenfingers gegenüber den nichtkodierenden Elektrodenfingern eine entsprechende Größe auf.

Bevorzugterweise umfasst die geometrische Eigenschaft des zumindest einen kodierenden Elektrodenfingers eine Breite des kodierenden Elektrodenfingers. Mit der Breite ist das Maß der Erstreckung quer zu einer Erstreckungs- oder Längsrichtung des Elektrodenfingers gemeint.

Zwischen jeweils zwei kodierenden Elektrodenfingern wird in einer bevorzugten Ausführungsform zumindest ein nichtkodierender Elektrodenfinger angeordnet. Hierdurch wird das Auslesen der Ziffer für den Fall vereinfacht, dass zwei in der Zahl aufeinanderfolgende Ziffern den gleichen Wert aufweisen. Der zwischen den beiden kodierenden Elektrodenfingern angeordnete nichtkodierende Elektrodenfinger stellt somit einen Abstandhalter zwischen den beiden zugeordneten Ziffern der Zahl in dem Stellenwertsystem dar. Hintergrund ist die optische Messtechnik: Es soll ein sicheres Auslesen auch unter Massenproduktionsbedingungen stattfinden können. Daher wird die Pseudo-Fehlerrate nicht erhöht.

In einer vorteilhaften Weiterbildung umfasst die geometrische Eigenschaft des zumindest einen kodierenden Elektrodenfingers eine Position auf der Oberfläche der Solarzelle. Mit anderen Worten, das Vorhandensein des kodierenden Elektrodenfingers in einer bestimmten Position repräsentiert einen bestimmten Wert für eine Ziffer der Zahl. Beispielsweise kann bei einem Binärsystem das Vorhandensein des Elektrodenfingers an einer vorbestimmten Position auf der Oberfläche der Solarzelle eine logische 1 repräsentieren. Dies hat den Vorteil, dass die zugehörige Ziffer mittels eines auf diese Position gerichteten Detektors auslesbar ist. Dies erfolgt beispielsweise mittels Bilderkennung unter Verwendung geeigneter Software.

Vorteilhafterweise umfasst die geometrische Eigenschaft des zumindest einen kodierenden Elektrodenfingers einen Abstand des kodierenden Elektrodenfingers gegenüber einem Rand der Solarzelle. Jedem erlaubten Abstandswert kann in diesem Fall ein Wert der zu dem kodierenden Elektrodenfinger gehörenden Ziffer in dem Stellenwertsystem zugeordnet sein.

In einer bevorzugten Ausführungsform weisen die kodierenden Elektrodenfinger und / oder die nichtkodierenden Elektrodenfinger eine im Wesentlichen gleiche Ausrichtung auf. Mit anderen Worten, sie erstrecken sich entlang zueinander im Wesentlichen parallelen Erstreckungsrichtungen. Beispielsweise können die nichtkodierenden Elektrodenfinger gemeinsam entlang einer Richtung ausgerichtet sein, während nichtkodierenden Elektrodenfinger zur Unterscheidung in eine andere Richtung weisen. Hierbei können Winkelabweichungen zwischen den kodierenden und den nichtkodierenden Elektrodenfingern jeweils ein zugehöriger Ziffernwert zugeordnet sein.

Gemäß einer Fortführung dieses Gedankens werden die kodierenden Elektrodenfinger und / oder die nichtkodierenden Elektrodenfinger im Wesentlichen entlang einer Geraden angeordnet. Werden beispielsweise die nichtkodierenden Elektrodenfinger entlang einer gemeinsamen Geraden angeordnet, so kann eine Abweichung von dieser Position durch einen kodierenden Elektrodenfinger leicht erkannt und abgelesen werden.

Vorteilhafterweise wird das Kennzeichen als ein alphanumerisches Kennzeichen ausgewählt. Derartige Kennzeichen umfassen auch rein numerische oder nur aus Buchstaben bestehende Kennzeichen.

Ferner ist das Stellenwertsystem in einer bevorzugten Ausführungsform ein Binärsystem. Dies hat den Vorteil, dass die Zahl problemlos in ein digitales Datenverarbeitungssystem aufgenommen werden kann. Zudem wird aufgrund des digitalen Charakters fehlerhaften Ablesungen effektiver vorgebeugt. Demgegenüber haben jedoch Stellenwertsystem, welche auf einer höheren Basis beruhen, beispielsweise Ternärsysteme, den Vorteil, dass größere Zahlenbereiche durch eine kleinere Anzahl an Ziffern und somit durch eine kleinere Anzahl an kodierenden Elektrodenfingern darstellbar sind.

In einer vorteilhaften Ausgestaltung umfasst das Aufbringen des Elektrodenfingermusters einen Siebdruckprozess, einen Galvanikprozess, einen Aufdampfprozess, einen Inkjet-Prozess, einen Sputter-Prozess und / oder einen Liftoff-Prozess. Hierbei kann der Galvanikprozess mit anderen Aufbringungsprozessen kombiniert werden, um die Dicke eines zuvor aufgebrachten Elektrodenfingermusters zu erhöhen. Beispielsweise kann mittels Siebdruck eine Saatschicht aufgebracht werden, welche mittels Galvanik-Beschichtung verstärkt wird. Gegenüber Siebdruckprozessen hat der Inkjet-Prozess den Vorteil, dass jedes Elektrodenfingermuster individuell gestaltet sein kann. Mit anderen Worten, jede hergestellte Solarzellen kann ein individuelles Elektrodenfingermuster und somit eine hierin codiertes Kennzeichen enthalten, beispielsweise ein Kennzeichen, das eine Seriennummer umfasst.

Zweckmäßigerweise wird das Elektrodenfingermuster auf einer Lichteinfallseite der Solarzelle aufgebracht. Dies hat den Vorteil, dass ein in dem Elektrodenfingermuster kodiertes Kennzeichen auch im Nachhinein, beispielsweise nach der Verkapselung der Solarzelle in einem Solarzellenmodul, erkannt oder ausgewiesen werden kann.

Gemäß einer besonderen Ausführungsform weist die hier vorgeschlagene Solarzelle auf: Eine Oberfläche und ein auf der Oberfläche aufgebrachtes Elektrodenfingermuster mit einer Mehrzahl elektrisch leitender Elektrodenfinger umfassend einen oder mehrere kodierende Elektrodenfinger, wobei eine kodierte Zahl, welche in einem Stellenwertsystem kodiert ist und ein Kennzeichen repräsentiert, durch eine geometrische Eigenschaft zumindest eines der kodierenden Elektrodenfinger derart repräsentiert ist, dass der kodierende Elektrodenfinger ein Verbindungsstück ist, welches als Brückenelement längere Leiterabschnitte an Leiterabschnittsendbereichen miteinander verbindet und welches in seinem Abstand gegenüber einem Rand der Solarzelle eine Versetzung gegenüber benachbarten Elektrodenfingern aufweist.

Ausführungsbeispiele der Erfindung werden anhand der Zeichnung näher erläutert. Es zeigen:
- Fig. 1: einen schematischen Ausschnitt einer Solarzelle mit einem Elektrodenfingermuster;
- Fig. 2: einen schematischen Ausschnitt einer weiteren Solarzelle mit einem Elektrodenfingermuster, welcher zumindest einen kodierenden Elektrodenfinger umfasst;
- Fig. 3: einen schematischen Ausschnitt einer dritten Solarzellen mit einem Elektrodenfingermuster mit zwei kodierenden Elektrodenfingern.

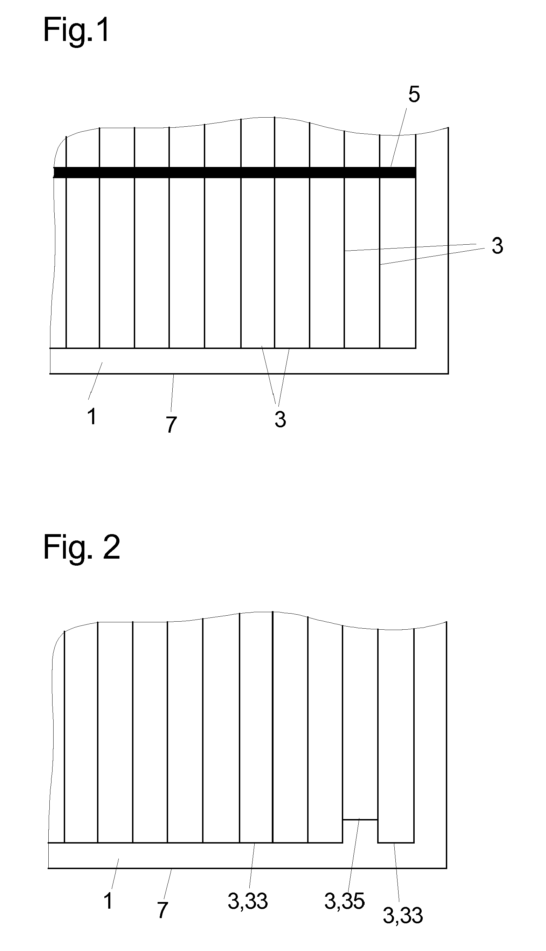

Die Fig. 1 zeigt ausschnittsweise eine Oberfläche einer frontseitenkontaktierten Solarzelle 1, auf der ein Elektrodenfingermuster mit mehreren Elektrodenfingern 3 sowie eine Busbar 5 aufgebracht ist. Die Elektrodenfinger 3 umfassen mehrere längere Elektrodenfinger 3, welche sich aus der Nähe eines Randes 7 der Solarzelle 1 zur Busbar 5 erstrecken und kürzere Elektrodenfinger 3, welche entlang des Randes 7 der Solarzelle 1 angeordnet sind und die freien Enden der längeren Elektrodenfinger 3 miteinander verbinden und somit Brücken hierzwischen bilden. In dem in der Fig. 1 dargestellten Fall ist die Solarzelle 1 nicht mit einem Kennzeichen markiert.

Demgegenüber zeigt die Fig. 2 eine Oberfläche einer Solarzelle 1, auf der ein Elektrodenfingermuster mit mehreren Elektrodenfingern 3 aufgebracht ist, welche kodierende Elektrodenfinger 35 sowie nichtkodierende Elektrodenfinger 33 umfassen. Einige der nichtkodierenden Elektrodenfinger 33 sind parallel zu einem Rand 7 der Solarzelle 1 und entlang einer gemeinsamen Linie angeordnet. Gegenüber diesen nichtkodierenden Elektrodenfingern 33 ist der kodierende Elektrodenfinger 35 von dem Rand 7 weg eingerückt. Dies kann beispielsweise als eine logische 1 in einem Binärsystem interpretiert werden. Die Codierung einer Ziffer mit Hilfe des kodierenden Elektrodenfingers 35 ist vorliegend je nach Sichtweise als eine Position des kodierenden Elektrodenfingers 35 auf der Oberfläche der Solarzelle 1, als ein Abstand des kodierenden Elektrodenfingers 35 von dem Rand 7 der Solarzelle 1 oder als eine Versetzung des kodierenden Elektrodenfingers 35 gegenüber den nichtkodierenden Elektrodenfingern 33 um eine bestimmte Entfernung realisiert.

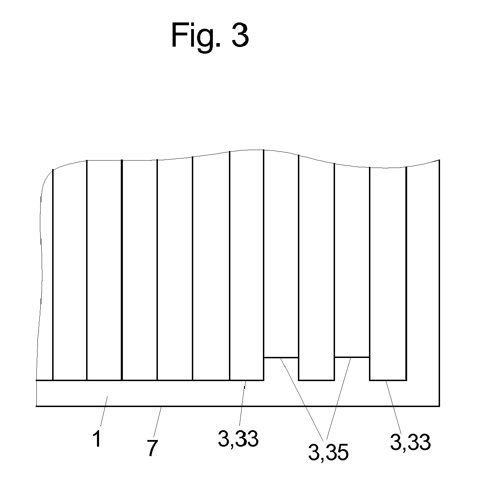

In der Fig. 3 ist eine Oberfläche einer Solarzelle 1 mit einem Elektrodenfingermuster dargestellt, das sich von dem Muster in der Fig. 2 durch einen weiteren kodierenden Elektrodenfinger 35 unterscheidet. Der weitere kodierende Elektrodenfinger 35 repräsentiert eine weitere Ziffer der Zahl in dem Stellenwertsystem. Alternativ kann der entsprechende Elektrodenfinger 3 in der Fig. 2 ebenfalls als ein kodierender Elektrodenfinger 35 angesehen werden, der jedoch in dem Stellenwertsystem die Ziffer 0 darstellt. Handelt es sich bei dem Stellenwertsystem um ein Binärsystem, so handelt es sich bei dem in Fig. 3 dargestellten Elektrodenfingermuster um die Repräsentation der Dezimalzahl 3.

Zwischen den beiden jeweils 1 Bit repräsentierenden kodierenden Elektrodenfingern 35 befindet sich ein nicht kodierender Elektrodenfinger 33. Dieser Zwischenfinger dient als Abstandhalter zwischen den kodierenden Elektrodenfingern 35, um ein sicheres und einfaches Auslesen zu gewährleisten. Würde dieser Zwischenfinger fehlen, bestünde die Gefahr, dass die beiden in der Fig. 3 dargestellten kodierenden Elektrodenfinger 35 als ein einziger kodierender Elektrodenfinger 35 interpretiert würden. Zusätzlich können die längeren, den nicht kodierender Elektrodenfinger 33 verbindenden Finger sowie der nicht kodierender Elektrodenfinger 33 selbst einen guten Stromabfluss am Rand der Solarzelle 1 gewährleisten.

Um das in der Fig. 3 dargestellte Elektrodenfingermuster mit der integrierten Markierung herzustellen, wird zunächst ein Kennzeichen ausgewählt, mit der die Solarzelle markiert werden soll. Dieses Kennzeichen, welches eine Reihe alphanumerischer Zeichen, einschließlich Satzzeichen oder anderer mittels eines ASCII-Codes darstellbarer Zeichen umfassen kann, wird anschließend mittels Codierung in eine Zahl in einem Stellenwertsystem kodiert. In dem Stellenwertsystem umfasst die Zahl mehrere Ziffern. Jede dieser Ziffern wird in dem anschließend zu erstellenden Elektrodenfingermuster durch zumindest einen kodierenden Elektrodenfinger 35 repräsentiert.

In dem vorliegenden Fall wird der Wert der Ziffer in dem Stellenwertsystem durch den Abstand eines zugehörigen kodierenden Elektrodenfingers 35 von einer gedachten Linie, welche die nichtkodierenden Elektrodenfinger 35 verbindet, oder durch den Abstand des kodierenden Elektrodenfingers 35 von dem Rand 7 der Solarzelle 1 repräsentiert. Der auf diese Weise gebildete, versetzte kodierende Elektrodenfinger 35 kann weiterhin seine Funktion zum Sammeln und / oder Weiterleiten von in der Solarzelle 1 erzeugten Strömen erfüllen. Eine durch die Markierung erfolgende Wirkungsgradminderung ist minimal oder nicht vorhanden.

### Bezugszeichenliste:

- 1: Solarzelle

- 3: Elektrodenfinger
- 33: nichtkodierende Elektrodenfinger
- 35: kodierende Elektrodenfinger

- 5: Busbar

- 7: Rand der Solarzelle

## Patentansprüche

1. Verfahren zur Markierung einer Solarzelle (1), umfassend die folgenden Schritte:
- Bereitstellen der Solarzelle (1);
- Auswählen eines Kennzeichens;
- Ermitteln einer in einem Stellenwertsystem kodierten Zahl mittels Kodieren des Kennzeichens in das Stellenwertsystem, wobei die Zahl in dem Stellenwertsystem das Kennzeichen repräsentiert; und
- Aufbringen eines Elektrodenfingermusters mit einer Mehrzahl von elektrisch leitenden Elektrodenfingern (3, 33, 35) auf einer Oberfläche der Solarzelle derart, dass die kodierte Zahl mittels einer geometrischen und / oder optischen Eigenschaft zumindest eines kodierenden Elektrodenfingers (35) aus der Mehrzahl von Elektrodenfingern (3, 33, 35) repräsentiert wird.

2. Verfahren nach Anspruch 1, **dadurch gekennzeichnet, dass** beim Aufbringen des Elektrodenfingermusters jede Ziffer der kodierten Zahl mittels einer geometrischen und / oder optischen Eigenschaft zumindest eines kodierenden Elektrodenfingers (35) aus der Mehrzahl von Elektrodenfingern (3, 33, 35) repräsentiert wird.

3. Verfahren nach Anspruch 2, **dadurch gekennzeichnet, dass** beim Aufbringen des Elektrodenfingermusters die geometrische und / oder optische Eigenschaft des zumindest einen kodierenden Elektrodenfingers (35), mittels der die Ziffer der Zahl repräsentiert wird, eine Abweichung in der Geometrie und / oder in den optischen Eigenschaften des zumindest einen kodierenden Elektrodenfingers (35) gegenüber nichtkodierenden Elektrodenfingern (33) aus der Mehrzahl von Elektrodenfingern (3, 33, 35) umfasst.

4. Verfahren nach Anspruch 3, **dadurch gekennzeichnet, dass** die geometrische Eigenschaft eine Versetzung des kodierenden Elektrodenfingers (35) gegenüber den nichtkodierenden Elektrodenfingern (33) umfasst.

5. Verfahren nach Anspruch 1 oder 2, **dadurch gekennzeichnet, dass** die geometrische Eigenschaft des zumindest einen kodierenden Elektrodenfingers (35) eine Breite des kodierenden Elektrodenfingers (35) umfasst.

6. Verfahren nach einem der vorangehenden Ansprüche, **dadurch gekennzeichnet, dass** zwischen jeweils zwei kodierenden Elektrodenfingern (35) zumindest ein nicht kodierender Elektrodenfinger (33) angeordnet wird.

7. Verfahren nach einem der Ansprüche 1 bis 5, **dadurch gekennzeichnet, dass** die geometrische Eigenschaft des zumindest einen kodierenden Elektrodenfingers (35) eine Position auf der Oberfläche der Solarzelle (1) umfasst.

8. Verfahren nach Anspruch 7, **dadurch gekennzeichnet, dass** die geometrische Eigenschaft des zumindest einen kodierenden Elektrodenfingers (35) einen Abstand des kodierenden Elektrodenfingers (35) gegenüber einem Rand (7) der Solarzelle (1) umfasst.

9. Verfahren nach einem der vorangehenden Ansprüche, **dadurch gekennzeichnet, dass** die kodierenden Elektrodenfinger (35) und / oder die nichtkodierenden Elektrodenfinger (33) eine im Wesentlichen gleiche Ausrichtung aufweisen.

10. Verfahren nach Anspruch 8, **dadurch gekennzeichnet, dass** die kodierenden Elektrodenfinger (35) und / oder die nichtkodierenden Elektrodenfinger (33) im Wesentlichen entlang einer Geraden angeordnet werden.

11. Verfahren nach einem der vorangehenden Ansprüche, **dadurch gekennzeichnet, dass** das Kennzeichen als ein alphanumerisches Kennzeichen ausgewählt wird.

12. Verfahren nach einem der vorangehenden Ansprüche, **dadurch gekennzeichnet, dass** das Stellenwertsystem ein Binärsystem ist.

13. Verfahren nach einem der vorangehenden Ansprüche, **dadurch gekennzeichnet, dass** das Aufbringen des Elektrodenfingermusters einen Siebdruckprozess, einen Galvanikprozess, einen Aufdampfprozess, einen Inkjet-Prozess, einen Sputter-Prozess und / oder einen Liftoff-Prozess umfasst.

14. Verfahren nach einem der vorangehenden Ansprüche, **dadurch gekennzeichnet, dass** das Elektrodenfingermuster auf einer Lichteinfallseite der Solarzelle aufgebracht wird.

15. Solarzelle (1) mit einer Oberfläche und einem auf der Oberfläche aufgebrachten Elektrodenfingermuster mit einer Mehrzahl elektrisch leitender Elektrodenfinger (3, 33, 35) umfassend einen oder mehrere kodierende Elektrodenfinger (35), wobei eine kodierte Zahl, welche in einem Stellenwertsystem kodiert ist und ein Kennzeichen repräsentiert, durch eine geometrische und / oder eine optische Eigenschaft zumindest eines der kodierenden Elektrodenfinger (35) repräsentiert ist.
